# EUROPÄISCHE PATENTSCHRIFT

(11) **EP 2 284 446 B1**
(45) Veröffentlichungstag und Bekanntmachung des Hinweises auf die Patenterteilung: **18.01.2017**
(21) Anmeldenummer: 10169249.9
(22) Anmeldetag: 12.07.2010
(51) Int. Cl.: F24C 7/08, F24C 15/10, H03K 17/94, H03K 17/96

(54) **Bedieneinheit zur Bedienersteuerung eines Kochfelds**
Operating unit to control a cooking hob
Unité de commande pour une plaque de cuisson

(30) Priorität: 27.07.2009 DE 102009035758
(43) Veröffentlichungstag der Anmeldung: 16.02.2011
(73) Patentinhaber: E.G.O. Elektro-Gerätebau GmbH, 75038 Oberderdingen (DE)
(72) Erfinder: Kleinhans, Andreas, 75031, Eppingen (DE); Kraus, Randolf, 75015, Bretten (DE)
(74) Vertreter: Patentanwälte Ruff, Wilhelm, Beier, Dauster & Partner mbB

(56) Entgegenhaltungen:
- EP-A1- 1 876 515
- WO-A1-2006/015711
- DE-A1-102005 018 298

## Beschreibung

Die Erfindung betrifft eine Bedieneinheit zur Bedienersteuerung eines Kochfelds.

Kochfelder umfassen üblicherweise mehrere, von einander getrennte Kochzonen. Eine jeweilige Kochzone kann einen oder mehrere, getrennt voneinander aktivierbare Heizkreise umfassen, wobei beispielsweise für ein Kochgefäß mit geringem Durchmesser lediglich ein innerer Heizkreis aktiviert wird und für ein Kochgefäß mit größerem Durchmesser zusätzlich zum inneren Heizkreis ein äußerer Heizkreis aktiviert werden kann.

Zur Bedienersteuerung von Kochfeldern sind Bedieneinheiten vorgesehen, mit denen unter anderem eine Heizleistung einer Kochzone einstellbar ist. Um eine Anzahl von notwendigen Bedien- bzw. Einstellelementen möglichst gering zu halten, kann es sinnvoll sein, Einstellelemente mehreren Kochzonen zuzuordnen. Hierzu kann beispielsweise pro Kochzone ein Bedienelement in Form eines Auswahlelements vorgesehen sein, mittels dessen eine Kochzone auswählbar ist. Zur Heizleistungseinstellung ist dann lediglich ein einzelnes Bedienelement in Form eines Einstellelements vorgesehen, umfassend beispielsweise eine Plus-Taste und eine Minus-Taste, mittels dessen Betätigung eine Heizleistung der ausgewählten Kochzone einstellbar ist. Wenn die entsprechende Kochzone mehrere Heizkreise aufweist, ist üblicherweise mindestens ein zusätzliches Bedienelement vorzusehen, mit dem beispielsweise ein zweiter Heizkreis aktiviert bzw. deaktiviert wird.

Kochfelder mit derartigen Bedieneinheiten sind aus der DE 10 2005 018298 A1, der EP 1 876 515 A1 und der WO 2006/015711 A1 bekannt.

Der Erfindung liegt die technische Aufgabe zugrunde, eine Bedieneinheit zur Bedienersteuerung eines Kochfelds zur Verfügung zu stellen, welche mit einer vergleichsweise geringen Anzahl von Bedienelementen eine komfortable und zuverlässige Bedienung ermöglicht.

Die Erfindung löst diese Aufgabe durch eine Bedieneinheit nach Anspruch 1.

Bevorzugte Ausführungsformen sind Gegenstand der Unteransprüche, deren Wortlaut hiermit durch Bezugnahme zum Inhalt der Beschreibung gemacht wird.

Die erfindungsgemäße Bedieneinheit dient zur Bedienersteuerung eines Kochfelds, das mindestens zwei voneinander getrennte Kochzonen aufweist. Mindestens eine der Kochzonen umfasst zwei getrennt voneinander aktivierbare Heizkreise, beispielsweise jeweils Strahlungsheizkörper und/oder Induktionsheizspulen umfassend. Die Bedieneinheit umfasst mindestens ein Auswahlelement, das zur Auswahl einer Kochzone dient. Zusätzlich ist mindestens ein Einstellelement vorgesehen, das zur Heizleistungseinstellung einer zuvor ausgewählten Kochzone dient. Eine Steuereinheit, beispielsweise in Form eines herkömmlichen Mikroprozessors, ist mit dem oder den Auswahlelementen und dem oder den Einstellelementen gekoppelt und detektiert deren Betätigung. Die Steuereinheit ist dazu ausgebildet, eine Betätigungsdauer des Auswahlelements zu erfassen. Hierzu ermittelt die Steuereinheit, wie lange ein Bediener bzw. Benutzer das Auswahlelement betätigt, beispielsweise seinen Finger auf einem Auswahlelement in Form einer kapazitiven Taste belässt. Wenn die Betätigungsdauer in einem ersten Zeitdauernbereich liegt, bewirkt die Betätigung eine Kochzonenauswahl. Wenn jedoch die Betätigungsdauer in einem zweiten, vom ersten Zeitdauernbereich verschiedenen Zeitdauernbereich liegt, wird mindestens einer der Heizkreise der ausgewählten Kochzone aktiviert bzw. deaktiviert. Wenn die ausgewählte Kochzone beispielsweise zwei Heizkreise aufweist, kann durch eine Betätigungsdauer im zweiten Zeitdauernbereich der zweite Heizkreis aktiviert bzw. deaktiviert werden, d. h. mittels des Auswahlelements ist zusätzlich zur Kochzonenauswahl auch ein Toggeln des zweiten Heizkreises möglich. Wenn die ausgewählte Kochzone mehr als zwei Heizkreise umfasst, können beispielsweise mittels der Betätigung des Auswahlelements sukzessive weitere Heizkreise zugeschaltet werden. Wenn schließlich alle Heizkreise der ausgewählten Kochzone aktiviert sind, kann entsprechend ein sukzessives Deaktivieren der Heizkreise erfolgen. Ein kurzes Betätigen des Auswahlelements kann beispielsweise eine Auswahl bewirken und eine längere Betätigung kann ein Zuschalten bzw. ein Abschalten eines Heizkreises bewirken. Bevorzugt wird für den zusätzlich aktivierten Heizkreis die Heizleistung des bereits aktivierten Heizkreises übernommen. Die erfindungsgemäße Bedieneinheit benötigt kein zusätzliches Bedienelement zur Aktivierung bzw. Deaktivierung des bzw. der weiteren Heizkreise, wodurch Bedienelemente eingespart werden können. Dies ermöglicht eine kostengünstigere Herstellung der Bedieneinheit bei gleichbleibender Bedienbarkeit.

In einer Weiterbildung sind die Zeitdauern des ersten Zeitdauernbereichs kleiner als die Zeitdauern des zweiten Zeitdauernbereichs, d. h. durch kurzes Betätigen erfolgt eine Auswahl und durch langes Betätigen erfolgt eine Aktivierung bzw. Deaktivierung der Heizkreise.

In einer Weiterbildung ist für jede Kochzone genau ein Auswahlelement vorgesehen.

In einer Weiterbildung ist ein einziges Einstellelement für alle Kochzonen vorgesehen. Das Einstellelement kann beispielsweise eine Plus-Taste zur Heizleitungserhöhung und eine Minus-Taste zur Heizleistungsreduktion umfassen.

In einer Weiterbildung ist das mindestens eine Auswahlelement und/oder das mindestens eine Einstellelement als kapazitives Sensorelement bzw. kapazitive Taste ausgeführt.

Bevorzugte Ausführungsformen der Erfindung sind in den Zeichnungen schematisch dargestellt. Hierbei zeigt:
- Fig. 1: ein Kochfeld mit einer erfindungsgemäßen Bedieneinheit,
- Fig. 2: ein Blockschaltbild der erfindungsgemäßen Bedieneinheit von Fig. 1 und
- Fig. 3a/b: Zeitablaufsdiagramme unterschiedlicher Bedienszenarien.

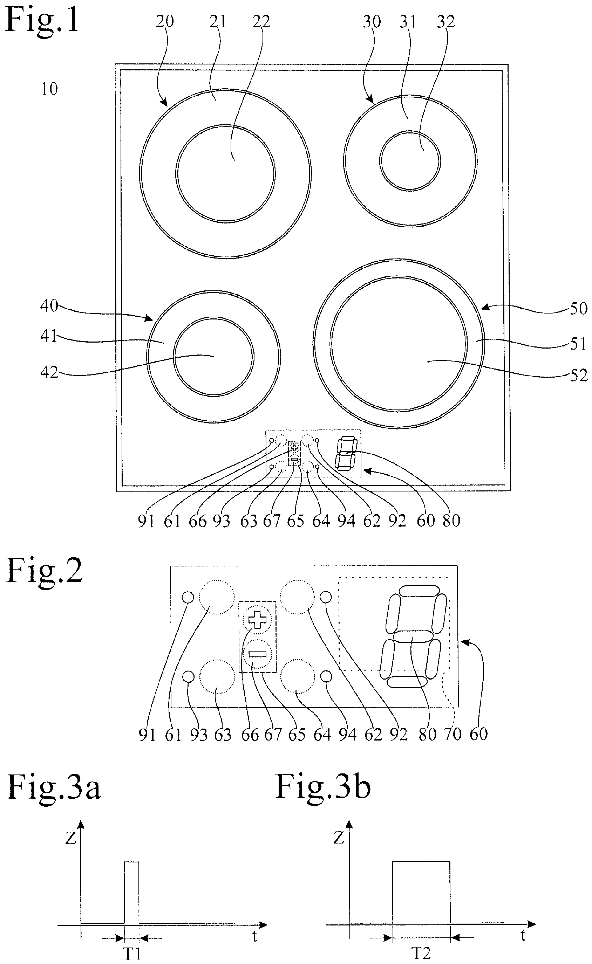

Fig. 1 zeigt ein Kochfeld 10, welches vier voneinander getrennte Kochzonen 20, 30, 40 und 50 aufweist. Die Kochzonen 20, 30, 40 und 50 weisen jeweils zwei getrennt voneinander aktivierbare Heizkreise 21 und 22, 31 und 32, 41 und 42, bzw. 51 und 52 auf, jeweils beispielsweise Strahlungsheizkörper umfassend. Es versteht sich, dass mehr oder weniger als die dargestellten Kochzonen vorhanden sein können. Selbstverständlich setzt die Erfindung nicht voraus, dass sämtliche Kochzonen mehrere Heizkreise aufweisen. Auch können mehr als zwei Heizkreise pro Kochzone vorhanden sein.

Zur Bedienersteuerung des Kochfelds 10 ist eine Bedieneinheit 60 vorgesehen, die pro Kochzone ein Bedienelement in Form eines Auswahlelements 61, 62, 63 und 64 jeweils in Form eines kapazitiven Sensorelements bzw. kapazitiven Tasters aufweist. Ein Bedienelement in Form eines Einstellelements 65, umfassend eine Plus-Taste 66 und eine Minus-Taste 67 jeweils in Form eines kapazitiven Sensorelements bzw. kapazitiven Tasters, dient zur Heizleistungseinstellung einer ausgewählten Kochzone.

Einem jeweiligen Auswahlelement 61, 62, 63 und 64 ist eine Leuchtdiode 91, 92, 93 bzw. 94 zugeordnet, wobei einen aktivierte Leuchtdiode 91, 92, 93 bzw. 94 anzeigt, dass die (geometrisch) auf dem Kochfeld 10 entsprechend angeordnete Kochzone ausgewählt ist. Eine Heizleistungsanzeige 80 zeigt die eingestellte Heizleistung der ausgewählten Kochzone an

Fig. 2 zeigt ein Blockschaltbild der Bedieneinheit 60 von Fig. 1. Die Auswahlelemente 61, 62, 63 und 64, die Leuchtdioden 91, 92, 93 und 94, die Heizleistungsanzeige 80 sowie das Einstellelement 65 bzw. 66 und 67 sind mit einer schematisch dargestellten Steuereinheit in Form eines Mikrocontrollers 70 gekoppelt, der eine Betätigung der Elemente 61, 62, 63, 64, 66 und 67 detektiert und eine Betätigungsdauer der Auswahlelemente 61, 62, 63 und 64 erfasst.

Fig. 3a/b zeigt unterschiedliche Betätigungsszenarien eines der Auswahlelemente 61, 62, 63 und 64. Bei einer kurzen Betätigung des Auswahlelements, siehe Teildiagramm (a), ermittelt die Steuereinheit 70 eine Betätigungsdauer T1 des Auswahlelements in einem ersten Zeitdauernbereich, beispielsweise in einem Zeitdauernbereich von 10ms bis 1000ms. Hieraus kann die Steuereinheit 70 ableiten, dass ein Benutzer eine Kochzonenauswahl vornehmen möchte. Die Steuereinheit 70 aktiviert folglich diejenige Kochzone, der das Auswahlelement zugeordnet ist, sowie die entsprechende Leuchtdiode. Der Bediener hat nun die Möglichkeit, die Heizleistung der betreffenden Kochzone mittels des Einstellelements 65 einzustellen, indem er durch Betätigen der Minus-Taste 67 die Heizleistung reduziert bzw. durch Betätigen der Plus-Taste 66 die Heizleistung erhöht. Die zugehörige Heizleistung wird in der Heizleistungsanzeige 80 dargestellt.

Wenn der Benutzer das Auswahlelement länger betätigt, bestimmt die Steuereinheit 70 eine Betätigungsdauer T2 (siehe Fig. 3, Teildiagramm (b)) in einem zweiten Zeitdauernbereich, beispielsweise in einem Zeitdauernbereich von 1500ms bis 3000ms. Darauf aktiviert bzw. deaktiviert die Steuereinheit 70 den äußeren Heizkreis der entsprechenden Kochzone. Ist beispielsweise aktuell die Kochzone 20 aktiviert, überprüft die Steuereinheit 70, ob der äußere Heizkreis 21 aktiviert ist oder nicht. Bei nicht aktiviertem äußeren Heizkreis 21 wird dieser aktiviert und bei aktiviertem äußeren Heizkreis 21 wird dieser deaktiviert. Langes Drücken des Auswahlelements 62 bewirkt folglich ein sogenanntes Toggeln des äußeren Heizkreises 21.

Nach einem erstmaligen Einschalten der Bedieneinheit bzw. nach einem Reset kann beispielsweise standardmäßig eine vorgegebene Kochzone aktiviert sein, ohne dass zuvor mittels des entsprechenden Auswahlelements diese Kochzone ausgewählt worden ist. Auf diese Weise wird sichergestellt, dass immer eine Kochzone ausgewählt ist. Falls eine solche standardmäßig Kochzonenvorauswahl nicht erfolgt, kann beispielsweise bei einer längeren Betätigung eines Auswahlelements, ohne dass zuvor eine Auswahl durch kurze Betätigung eines Auswahlelements erfolgt ist, keine Aktion bzw. kein Toggeln erfolgen oder anstatt des normalerweise erfolgenden Toggelns des Heizkreises lediglich eine Auswahl der zugehörigen Kochstelle stattfinden.

Bei der gezeigten Ausführungsform ist pro Kochzone genau ein Auswahlelement vorgesehen. Alternativ kann auch nur ein einzelnes, gemeinsames Auswahlelement für alle Kochzonen vorgesehen sein. Bei einer kurzen Betätigung des Auswahlelements erfolgt hierbei die Auswahl einer jeweils nachfolgenden Kochzone, beispielsweise beginnend bei der Kochzone 20, zur Kochzone 30 bis zur Kochzone 50 und anschließend wieder zur Kochzone 20 usw. Ein längeres Drücken des Auswahlelements bewirkt ein Aktivieren bzw. Deaktivieren des äußeren Heizkreises der aktuell ausgewählten Kochzone.

Die gezeigten Ausführungsformen ermöglichen eine komfortable und zuverlässige Bedienung mit einer vergleichsweise geringen Anzahl von Bedienelementen.

## Patentansprüche

1. Bedieneinheit (60) zur Bedienersteuerung eines Kochfelds (10), das mindestens zwei voneinander getrennte Kochzonen (20, 30, 40, 50) umfasst, wobei mindestens eine der Kochzonen (20, 30, 40, 50) zwei getrennt voneinander aktivierbare Heizkreise (21, 22; 31, 32; 41, 42; 51,52) aufweist, wobei die Bedieneinheit umfasst:
- mindestens ein Auswahlelement (61, 62, 63, 64), mittels dessen Betätigung eine Kochzone (20, 30, 40, 50) auswählbar ist,
- mindestens ein Einstellelement (65; 66, 67), mittels dessen Betätigung eine Heizleistung einer ausgewählten Kochzone (20,30,40,50) einstellbar ist, und
- eine Steuereinheit (70), die mit dem mindestens einen Auswahlelement (61, 62, 63, 64) und dem mindestens einen Einstellelement (65, 66, 67) gekoppelt ist und die eine Betätigung des mindestens einen Auswahlelements (61, 62, 63, 64) und des mindestens einen Einstellelements (65, 66, 67) detektiert,
**dadurch gekennzeichnet, dass**
- die Steuereinheit (70) dazu ausgebildet ist,
- eine Betätigungsdauer des Auswahlelements (61, 62, 63,64) zu erfassen,
- bei einer Betätigungsdauer in einem ersten Zeitdauernbereich eine Kochzone (20, 30, 40, 50) auszuwählen und
- bei einer Betätigungsdauer in einem zweiten, vom ersten Zeitdauernbereich verschiedenen Zeitdauernbereich mindestens einen der mindestens zwei Heizkreise (21, 22, 31, 32, 41, 42, 51, 52) der ausgewählten Kochzone (20, 30, 40, 50) zu aktivieren oder zu deaktivieren.

2. Bedieneinheit nach Anspruch 1, **dadurch gekennzeichnet, dass** Zeitdauern des ersten Zeitdauernbereichs kleiner sind als Zeitdauern des zweiten Zeitdauernbereichs.

3. Bedieneinheit nach Anspruch 1 oder 2, **dadurch gekennzeichnet, dass** für jede Kochzone (20, 30, 40, 50) genau ein Auswahlelement (61, 62, 63, 64) vorgesehen ist.

4. Bedieneinheit nach einem der vorhergehenden Ansprüche, **dadurch gekennzeichnet, dass** ein einziges Einstellelement (65, 66, 67) für alle Kochzonen (20, 30, 40, 50) vorgesehen ist.

5. Bedieneinheit nach einem der vorhergehenden Ansprüche, **dadurch gekennzeichnet, dass** das mindestens eine Auswahlelement (61, 62, 63, 64) und/oder das mindestens eine Einstellelement (65, 66, 67) kapazitive Sensorelemente sind.

## Claims

1. An operator control unit (60) for operator control of a cooktop (10) which comprises at least two cooking zones (20, 30, 40, 50) which are separated from one another, with at least one of the cooking zones (20, 30, 40, 50) having two heating rings (21, 22; 31, 32; 41, 42; 51, 52) which can be activated separately from one another, with the operator control unit comprising:
- at least one selection element (61, 62, 63, 64), it being possible to select a cooking zone (20, 30, 40, 50) by operating said selection element,
- at least one adjusting element (65; 66, 67), it being possible to adjust a heating power of a selected cooking zone (20, 30, 40, 50) by operating said adjusting element, and
- a control unit (70) which is coupled to the at least one selection element (61, 62, 63, 64) and the at least one adjusting element (65, 66, 67) and which detects operation of the at least one selection element (61, 62, 63, 64) and the at least one adjusting element (65, 66, 67),
**characterized in that**
- the control unit (70) is designed
- to record an operating duration of the selection element (61, 62, 63, 64),
- to select a cooking zone (20, 30, 40, 50) in the event of an operating duration in a first time period range, and
- to activate or to deactivate at least one of the at least two heating rings (21, 22, 31, 32, 41, 42, 51, 52) of the selected cooking zone (20, 30, 40, 50) in the event of an operating duration in a second time period range which differs from the first time period range.

2. The operator control unit according to claim 1, **characterized in that** time periods of the first time period range are shorter than time periods of the second time period range.

3. The operator control unit according to claim 1 or 2, **characterized in that** precisely one selection element (61, 62, 63, 64) is provided for each cooking zone (20, 30, 40, 50).

4. The operator control unit according to any one of the preceding claims, **characterized in that** a single adjusting element (65, 66, 67) is provided for all the cooking zones (20, 30, 40, 50).

5. The operator control unit according to any one of the preceding claims, **characterized in that** the at least one selection element (61, 62, 63, 64) and/or the at least one adjusting element (65, 66, 67) are capacitive sensor elements.

## Revendications

1. Unité de commande (60) pour la commande d'utilisateur d'une plaque de cuisson (10), qui comprend au moins deux zones de cuisson (20, 30, 40, 50) séparées les unes des autres, dans laquelle au moins une des zones de cuisson (20, 30, 40, 50) présente deux cercles de chauffage (21, 22; 31, 32; 41, 42; 51, 52) activables séparément l'un de l'autre, dans laquelle l'unité de commande comprend:
- au moins un élément de sélection (61, 62, 63, 64), dont l'actionnement permet de sélectionner une zone de cuisson (20, 30, 40, 50),
- au moins un élément de réglage (65; 66, 67), dont l'actionnement permet de régler la puissance de chauffage d'une zone de cuisson sélectionnée (20, 30, 40, 50), et
- une unité de commande (70), qui est couplée audit au moins un élément de sélection (61, 62, 63, 64) et audit au moins un élément de réglage (65, 66, 67) et qui détecte un actionnement dudit au moins un élément de sélection (61, 62, 63, 64) et dudit au moins un élément de réglage (65, 66, 67),
**caractérisée en ce que**
- l'unité de commande (70) est configurée pour
- détecter une durée d'actionnement de l'élément de sélection (61, 62, 63, 64),
- pour une durée d'actionnement dans une première plage de durée, sélectionner une zone de cuisson (20, 30, 40, 50), et
- pour une durée d'actionnement dans une deuxième plage de durée, différente de la première plage de durée, activer ou désactiver au moins un desdits au moins deux cercles de chauffage (21, 22; 31, 32; 41, 42; 51, 52) de la zone de cuisson sélectionnée (20, 30, 40, 50).

2. Unité de commande selon la revendication 1, **caractérisée en ce que** des durées de la première plage de durée sont plus petites que des durées de la deuxième plage de durée.

3. Unité de commande selon la revendication 1 ou 2, **caractérisée en ce qu'**il est prévu exactement un élément de sélection (61, 62, 63, 64) pour chaque zone de cuisson (20, 30, 40, 50).

4. Unité de commande selon l'une quelconque des revendications précédentes, **caractérisée en ce qu'**il est prévu un seul élément de réglage (65, 66, 67) pour toutes les zones de cuisson (20, 30, 40, 50).

5. Unité de commande selon l'une quelconque des revendications précédentes, **caractérisée en ce que** ledit au moins un élément de sélection (61, 62, 63, 64) et/ou ledit au moins un élément de réglage (65, 66, 67) sont des éléments de capteur capacitifs.
